# EUROPEAN PATENT APPLICATION

(11) **EP 4 535 011 A1**
(43) Date of publication of application: **09.04.2025**
(21) Application number: 24203804.0
(22) Date of filing: 01.10.2024
(51) Int. Cl.: G01R 1/04, G01R 15/16

(54) **CAPACITIVE VOLTAGE TEST SYSTEM**

(30) Priority: 04.10.2023 US 202363542410 P
(71) Applicant: Kries-Energietechnik GmbH & Co. KG, 71334 Waiblingen (DE)
(72) Inventor: Kries, Gunter, 71334 Waiblingen (DE)
(74) Representative: Grünecker Patent- und Rechtsanwälte PartG mbB

(57) **Abstract**

The present invention provides a capacitive voltage test system configured to perform a voltage test on a medium to high voltage termination, in particular an elbow connector, comprising a capacitive test point which is capacitively coupled to a medium to high voltage cable of the termination for voltage detection and/or measurement, and a test point cap which is mounted on the capacitive test point, the test point cap having a signal contact configured to transmit a detection and/or measurement signal and a ground contact configured to derive a capacitive test signal, and the ground contact being configured to establish a conductive contact with a grounded surface of the termination only when the test point cap is correctly mounted on the capacitive test point and an electrical connection is established between the test point and the signal contact. This capacitive voltage test system offers a safe and efficient solution for testing medium to high voltage terminations. Its configuration prioritizes operator safety and ensures accurate detections and measurements while reducing the risks typically associated with such operations. By integrating features like the capacitive test point and the carefully designed test point cap with its specific contacts, the system delivers both operational excellence and safety.

## Description

### BACKGROUND OF THE INVENTION

Capacitive voltage test systems, as used in medium to high voltage installations, provide non-intrusive voltage detections and measurements, ensuring both safety and accurate readings. Guidelines, requirements and best practices associated with the design, application and testing of such capacitive voltage test systems in the context of high-voltage equipment are described, for example, in the International Electrotechnical Commission (IEC) standard IEC 62271-213.

Capacitive voltage test systems using C1 coupling electrodes have grown in popularity and use due to the increased safety and reliability they offer. By not requiring direct contact with the circuit or terminal to detect and measure voltage, the risk of electrical shock or arc flash is significantly reduced. This is especially crucial in high-voltage settings where direct contact can be fatal. Therefore, C1 coupling electrodes often become a permanent part of many high-voltage systems. This permanence ensures that the electrode's position, condition, and relationship to the equipment remain consistent over time, which in turn offers a reliable and repeatable detection and measurement point. It eliminates the variables introduced by using different contact points or relying on technicians to choose an appropriate contact location.

It is paramount that the signal from the secondary side of the C1 coupling electrode reaches an evaluation device without interference or degradation. Any compromise in this connection can lead to false readings or misinterpretations. This evaluation device interprets the signals from the C1 coupling electrode. It can indicate if voltage is present (or absent), ensuring that technicians can verify the equipment's status before performing maintenance or other tasks.

IEC 62271-213 illustrates the configuration of the C1 coupling electrode's connections to both the primary and secondary sides, with an evaluation device plugged into a designated test point. Given the importance of high-voltage installations in power infrastructure and the inherent dangers associated with high voltage, standards like IEC 62271-213 are critical. They provide guidelines and best practices for designing, implementing, and testing equipment to ensure both operational efficiency and safety.

Elbow connectors (or plugs) are specifically designed for compact high voltage connection points, often used in underground or submersible applications. The integration of C1 coupling electrodes into the connector body is a strategic way of facilitating non-intrusive voltage testing without the need for direct contact with live components. This integrated design minimises the need for external hardware or modifications to incorporate voltage testing capabilities. It streamlines the design and reduces potential points of failure. By default, the test point is shielded by a protective test point cap. This serves several purposes: It protects the test point from environmental factors, debris and potential mechanical damage; ensures safety by preventing accidental contact with the test point; and provides a barrier against accidental shorting or grounding, especially in environments with conductive elements such as water.

The provision of a signal output in the protective test point cap allows a stationary voltage test system to be connected even when the cap is in place. This facilitates continuous or periodic monitoring without the need to continually remove and replace the cap. The ability to remove the cap with a hotstick (an insulated pole tool, often made of fiberglass) enhances safety by allowing technicians to distance themselves from high voltage components. It is especially useful in high-voltage scenarios or tight spaces where manual operation might be hazardous. While stationary voltage test systems provide continuous or periodic monitoring, there are scenarios where a separate, non-stationary voltage test system may be required. The design allows easy switching between these methods to meet both routine monitoring and specialised testing requirements.

The test point cap may have a tab with an opening to allow the use of the hotstick for safe remote operation. The moment the cap is removed, the path for the signal to the stationary evaluation device is interrupted. This can serve as both a safety feature and a potential pitfall. On the one hand, it prevents unauthorized or untrained individuals from attempting to manipulate the system, since removing the cap would disrupt the signal. On the other hand, however, if not accounted for, the lack of signal may be misconstrued as an absence of voltage, leading to false safety assumptions.

Particularly in setups where the test point is not directly visible due to system enclosure, there is a potential for human error. Operators might not realize the cap has been removed, leading them to interpret the lack of signal as an absence of voltage.

There is therefore an urgent need to address the potential for misinterpretation and ensure that any anomaly, such as the removal of the cap, is clearly identified and cannot be confused with standard operational signals, particularly those indicating a safe condition.

There are capacitive voltage test systems on the market which use signal cable monitoring devices to compare the ground potential on the coupling electrode side with the ground potential on the evaluation device side (see DE 20 2004 012 798 U1). The advantage of signal cable monitoring devices is that they can detect a broken signal line, especially if the cable shield is interrupted. This is valuable in ensuring line continuity and can be used as a safety or verification mechanism. However, the limitation of this current technology is that even if the signal cable monitoring devices can detect a broken line due to an interrupted cable shield, they cannot ascertain the connection status at the test point. Especially the presence or proper seating of the test point cap on the elbow (right-angle) connector, is a considerable safety concern. In situations where the cap is not seated correctly on the elbow connector, even if the signal contact is fully intact, there is a risk of the test system delivering a false negative, indicating that no voltage is present when in fact it is. This could lead technicians into a false sense of security when working on the system.

In addition, partial discharge (PD) is a phenomenon that can occur within insulating materials when there is a localised dielectric breakdown of a small portion of the insulating material. It results in a short-lived discharge of electricity between two conducting phases, often within a gas bubble trapped in solid or liquid insulation. Over time, partial discharges can degrade the insulating material, leading to eventual failure of the insulating system. Therefore, detecting and monitoring PD activity is critical in high and medium voltage systems to ensure the integrity and safety of electrical installations. In this connection, DE 10 2021 201 465 A1 describes an arrangement that uses the capacitance of a medium-voltage cable to decouple higher-frequency signals in the kHz to MHz range.

### BRIEF DESCRIPTION OF THE INVENTION

A capacitive voltage test system according to the present invention is configured to perform a voltage test on a medium to high voltage termination, in particular an elbow connector, and comprises a capacitive test point which is capacitively coupled to a medium to high voltage cable of the termination for voltage detection and/or measurement, and a test point cap which is mounted on the capacitive test point, the test point cap having a signal contact configured to transmit a detection and/or measurement signal and a ground contact configured to derive a capacitive test signal, and the ground contact being configured to establish a conductive contact with a grounded surface of the termination only when the test point cap is correctly mounted on the capacitive test point and an electrical connection is established between the test point and the signal contact.

This invention provides a solution to a critical problem in medium to high voltage terminations, such as elbow connectors, ensuring safety and accuracy in voltage detections and measurements.

The capacitive test point provides a non-intrusive contact point (without directly tapping into the medium to high voltage cable) for voltage detections and measurements, making the process safer. This reduces the risk of electrical accidents during detection and measurement.

The test point cap is a protective covering, which, at the same time, serves as an interface between the evaluation (detecting and/or measuring) device and the capacitive test point. Its configuration ensures that only correct and proper mounting will allow for accurate voltage detection and/or measurement. While the signal contact of the test point cap is the primary interface that captures the detection and/or measurement signal from the capacitive test point, the ground contact of the test point cap has a dual function. Besides serving as a grounding reference, it also acts as a safety check, ensuring that the test point cap is correctly mounted before transmitting a detection and/or measurement signal.

The capacitive voltage test system of the present invention offers several distinct advantages. The system ensures that only when the test point cap is correctly mounted will a detection/measurement be made. This design minimizes the risk of false readings or potential electrical hazards. By ensuring proper mounting and grounding before making a detection/measurement, the system guarantees accurate and reliable readings. While the invention's primary application is mentioned for elbow connectors, the design could easily be adapted for other medium to high voltage terminations. By incorporating visual or auditory indicators that signal when the test point cap is properly seated, users can be confident in their connection before making a detection/measurement. The system's design, which demands proper seating for functionality, minimizes the risk of false negatives. This can be especially critical in scenarios where assuming the absence of voltage might lead to hazardous situations. In summary, the present invention provides a robust and safe method for detecting/measuring voltage in medium to high voltage terminations, ensuring both user safety and detection/measurement accuracy.

According to a preferred embodiment of the present invention, the capacitive voltage system further comprises an evaluation device connected to both the signal contact and the ground contact via a signal line, wherein the ground contact is configured to lag both mechanically and electrically behind the signal contact such that the evaluation device is configured to immediately detect an open ground contact and trigger a warning signal even if the signal contact remains connected to the test point.

This preferred embodiment further refines the safety and reliability aspects of the capacitive voltage test system, making it an excellent tool for medium to high voltage testing scenarios. By incorporating a mechanism in the form of the evaluation device that can immediately detect an open ground contact and subsequently provide a warning, the system becomes safer for users and reduces the risk of inaccurate readings.

The lagging ground contact is designed such that it makes contact after the signal contact, both mechanically and electrically. This 'lag' ensures that the ground connection is the last to connect and the first to disconnect. The evaluation device evaluates the electrical contacts' states and can detect if there is an open ground connection. Given the described configuration, even if the signal contact is connected, an open ground contact would still be detected. Upon detecting an open ground contact, the evaluation device will immediately trigger a warning signal. This could be a visual alarm, auditory alarm, or both, alerting the user of the incorrect or unsafe configuration, and thereby significantly reducing the risk of mishaps.

According to a further preferred embodiment of the present invention, the grounded surface is connected to system ground via a ground connection line passing through a low-pass filter integrated on the ground side of a contact point, where a shield of the cable is connected to the ground connection line, so that higher-frequency signals from the shield are routed away from the system ground through the contact point, the grounded surface, the ground contact and the signal line to the evaluation device for partial discharge detection.

This further preferred embodiment introduces an advanced mechanism for partial discharge (PD) detection in the capacitive voltage test system. Detecting PD is crucial for the health monitoring and maintenance of medium to high voltage systems.

To achieve the above goal, a low-pass filter is integrated on the ground side of a contact point. This filter only allows low-frequency signals to pass through to the system ground and blocks high-frequency signals which are indicative of partial discharges. The shield of the medium or high voltage cable is connected to the ground connection line. This shield often picks up the high-frequency signals from partial discharges. Rather than being dissipated into the system ground, the high-frequency signals from the shield are deliberately routed through a pathway (i.e., contact point → grounded surface → ground contact) to the evaluation device for analysis. The evaluation device is configured to detect and analyze these high-frequency signals, determining if they are indicative of partial discharges (PD) within the system. Detecting PD early allows for preventative maintenance, avoiding costly repairs or failures.

According to an alternative preferred embodiment of the present invention, the grounded surface is connected in a semiconducting manner to system ground and higher-frequency signals from a shield of the cable are routed through a contact point, a DC blocking capacitor, the ground contact and the signal line to the evaluation device for partial discharge detection, while a low-pass filter integrated on the ground side of the contact point blocks said higher-frequency signals from leaking from the shield into the system ground.

For terminals like elbow connectors/plugs, the housing can be made semiconducting. Thus, the surface of this semiconducting housing provides an optimal surface for grounding operational and low-frequency signals, whilst preventing unwanted short-circuiting of high-frequency signals.

### BRIEF DESCRIPTION OF THE DRAWING FIGURES

The above and other features of the present invention are also shown in the following drawings:
- FIG. 1: illustrating an enlarged detail of an elbow connector body provided with a capacitive test point on which a protective test point cap is mounted;
- FIG. 2: illustrating an elbow connector equipped with a capacitive voltage test system according to the present invention in a faulty contact state due to an incorrectly mounted test point cap;
- FIG. 3: illustrating the elbow connector of FIG. 2 with the protective test point cap unmounted;
- FIG. 4: illustrating the elbow connector of FIG. 2 with the capacitive voltage test system being in a full-contact state due to a correctly mounted test point cap; and
- FIG. 5: illustrating an elbow connector equipped with an alternative capacitive voltage test system according to the present invention for additional partial discharge (PD) analysis.

### DETAILED DESCRIPTION OF THE INVENTION

The following description of exemplary embodiments of the invention is not intended to limit the scope of the invention to these exemplary embodiments, but rather to enable any person skilled in the art to make and use the invention.

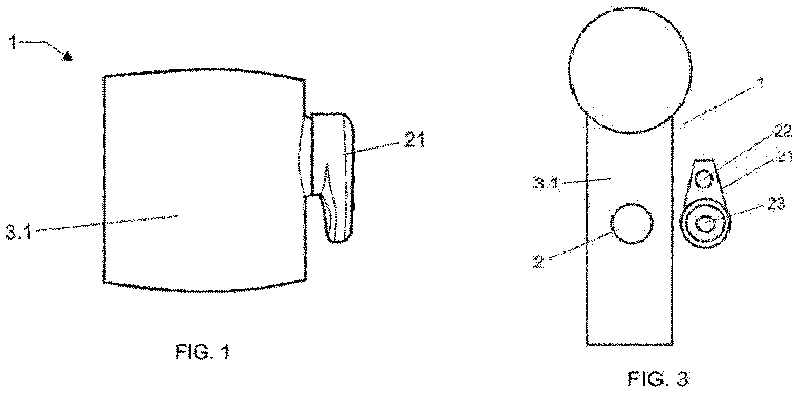

The embodiments illustrated in FIGS. 1 to 5 highlight a potential problem in the design of so-called elbow connectors (or plugs) 1 used for high voltage connections. The crux of the matter is ensuring the safety and reliability of a capacitive voltage test system for performing a voltage test on such an elbow connector 1. The safety concern stems from the potential misinterpretation of the voltage display 31 on the evaluation device 30 of the capacitive voltage system, particularly if the protective test point cap 21 covering the capacitive test point 2 is not properly positioned or is removed altogether.

The housing 3.1 of the elbow connector 1 provides structural integrity and protection for its internal components. Additionally, it plays an active role in facilitating voltage detections and measurements by housing the C1 coupling electrodes. Safely nestled inside the housing 3.1, these electrodes are integral to the elbow connector's 1 functionality. They are responsible for detecting and measuring the voltage, enabling accurate readings and ensuring system safety.

The capacitive test point 2 is the elbow connector's 1 most exposed feature. Its radial outward projection from the housing 3.1 grants technicians direct access for voltage testing. However, the exposed design poses a risk, making it vulnerable to unintentional touch or external impacts that could displace or damage it. Given the vulnerabilities of the capacitive test point 2, a protective test point cap 21 is used to shield it (see FIG. 1). This cap 21 acts as a protective barrier, preventing accidental contact, dirt, debris, or water ingress.

However, this cap 21 is not just a mere protective shield for the test point 2; it houses the integral signal contact 23, which is a critical component in the voltage testing process. It is the primary medium through which the voltage detection and/or measurement signal is captured from the test point 2. The efficiency of this contact 23 ensures that accurate and reliable signals are obtained for evaluation and appropriate signal division is performed. A coaxial cable 24 serves as the signal line for transmitting voltage readings to the evaluation device 30. This device 30 is responsible for interpreting the transmitted voltage readings, which might subsequently be displayed, recorded, or analyzed based on the system's requirements. When the protective test point cap 21 is securely and correctly mounted on the test point 2, the signal contact 23 establishes a firm electrical connection with the test point 2. This connection activates the voltage testing pathway. The captured signal travels through the coaxial cable 24, ensuring that the integrity of the data is maintained, finally reaching the evaluation device 30 for processing.

The process of capacitive decoupling is critical for high-voltage applications. By creating a capacitive coupling, the voltage test system can isolate or "decouple" high-frequency noise or disturbances, allowing only the relevant signals to pass through. This ensures that only the desired detection and/or measurement signal is forwarded to the evaluation device 30. The test point cap 21, when connected to the grounded evaluation device 30, presents a low impedance pathway for the signal. Low impedance ensures that most of the signal is channeled through the path, minimizing losses and ensuring that the signal remains strong and clear for processing. By terminating the signal contact 23 with the grounded evaluation device 30, the high-voltage signal is effectively reduced to a lower, safer voltage level. This allows the evaluation device 30 to process the signal without the risks associated with high voltage. Moreover, at this reduced voltage level, the electronic circuit within the evaluation device 30 can then easily detect/measure the signal with greater precision and accuracy. Modern electronic circuits are designed to operate at specific voltage levels, typically much lower than the operational voltages of high-voltage systems. By reducing the signal to these levels, the evaluation device 30 can use standard electronic components and circuits to process the signal, making the entire system more cost-effective and easier to manufacture.

A hotstick is a specialized tool designed for safe operation in high-voltage situations. As seen in FIG. 3, the test point cap's 21 design includes a dedicated tab with an opening 22. This tab is optimized for grip and maneuverability when engaged with a hotstick. The opening 22 allows the hotstick to securely latch onto the cap 21, ensuring a firm grip during the removal process. By facilitating the cap's 21 remote removal, operators have the flexibility to use alternative, non-stationary voltage test systems. This adaptability is crucial in situations where the primary evaluation device 30 might not be available, functional, or suitable for specific testing requirements.

The paramount safety concern here is the potential misreading on the evaluation device 30. There is a risk that when the protective cap 21 is not properly positioned on the test point 2, the evaluation device 30 might show no voltage, even when voltage is indeed present at the C1 coupling electrode. An operator might mistakenly believe the system is de-energized when it is not. Such a misinterpretation can have severe consequences, leading to unsafe situations for technicians or other personnel working around or with the high-voltage system.

Given this background, the present invention provides a solution to mitigate the described safety concern, ensuring that even in cases where the protective test point cap 21 is not properly placed or is absent, the evaluation device 30 provides accurate and safe readings to the users.

This solution consists of the incorporation of a grounding mechanism in the test point cap 21 of the elbow connector 1, ensuring both safety and functionality. The test point cap 21 connects to the coaxial cable 24, which is a high-fidelity cable used for signal transmission. The coaxial cable 24 has a central conductor and an outer cable shield 25. While the central conductor carries the detection and/or measurement signal, the shield 25 of the coaxial cable 24 carries the ground potential.

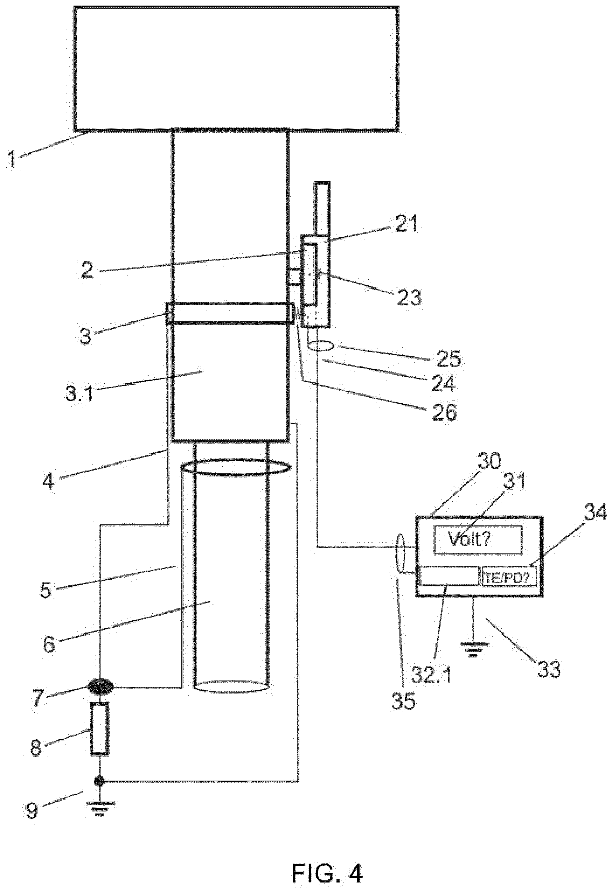

In addition to the signal contact 23, the test point cap 21 incorporates a ground contact 26. This ground contact 26 ensures that when the cap 21 is correctly mounted on the test point 12 (in a full-contact state, as shown in FIG. 4), it establishes a connection with a contact surface 3 on the elbow plug 1, which is grounded. This ground connection ensures that the entire high-voltage system 11 remains grounded. When the test point cap 21 is in its rightful place and both the signal and ground contacts 23, 26 are in mechanical and electrical contact (see FIG. 4), the voltage detection and/or measurement signal can be accurately transmitted to the evaluation device 30 via the central conductor of the coaxial cable 24, and, simultaneously, the ground potential can be correctly routed through the coaxial cable's shield 25 to the evaluation device 30.

By incorporating both the signal contact 23 and the ground contact 26 in the test point cap 21, the configuration ensures that accurate voltage readings are obtained only when the cap 21 is correctly mounted and the system is safely grounded. This dual-contact mechanism acts as a built-in safety feature, preventing erroneous readings and potential hazards associated with improperly grounded systems. The use of a coaxial cable 24 further reinforces the signal quality and grounding efficacy of the system.

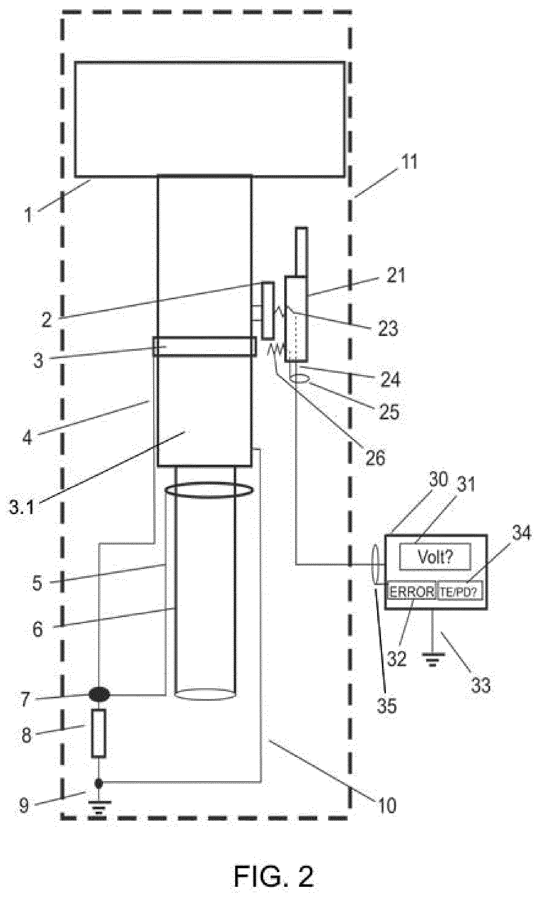

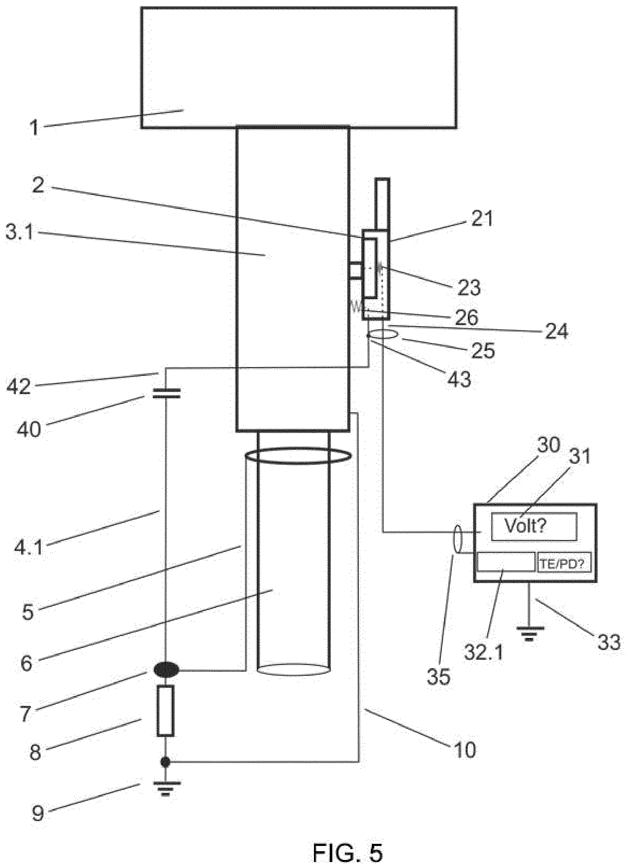

The grounding mechanism for the elbow connector 1 can be implemented in two different ways to ensure safety and proper functioning for medium to high voltage systems. Both ways are used to ensure that the elbow connector 1 maintains a safe potential relative to its surroundings, which is crucial for the safety of operators and equipment. The first way (illustrated in FIGS. 2 and 4) is that the grounded surface 3 of the elbow plug 1 is directly connected to the ground 9 of the high-voltage system 11 via a ground connection line 4. The second way (illustrated in FIG. 5) is that the surface of the housing 3.1 of the elbow connector 1 is made semiconducting. Semiconducting materials have the unique property of conducting electricity under certain conditions, which can be utilized to manage stray currents or induced voltages in a controlled manner. The housing 3.1 of the elbow connector 1, which is semiconducting, is then connected to the system ground 9 through a housing ground line 10 at some other point. This indirect grounding can offer some advantages, such as providing a controlled path for certain frequencies or conditions, filtering unwanted noise, or enabling specific diagnostic functions.

The present invention provides a smart safety mechanism that ensures proper operation of the capacitive voltage test system and also prevents false readings or interpretations. A further key component here is the sequential or lagging behavior of the contacts 23, 26 in the test point cap 21. The contact mechanism is configured in such a way that the signal contact 23 connects first during cap attachment and disconnects last during cap detachment,

Consequently, If the test point cap 21 is not fully or correctly attached, there is a possibility that the ground contact 26 might not make a connection while the signal contact 23 contact still does. This faulty contact condition (illustrated in FIG. 2) ensures that an open ground contact can be immediately detected without the risk of a false positive voltage reading.

If the configuration were reversed (i.e., the ground contact disconnected after the signal contact), there would be an extremely dangerous risk of a false positive, where the voltage test system would indicate that there is no voltage when there is.

When the evaluation device 30 detects that the ground contact 26 is interrupted while the signal contact 23 is still active, it can trigger a warning signal 32. This immediate feedback informs the operator that the test point cap 21 has not been correctly fitted (mounted) and that the voltage readings might be inaccurate. Such a configuration minimizes the risk of operational errors. If an operator sees a voltage reading without any warning, he or she may wrongly assume the system is safe, leading to potential accidents or equipment damage. The warning signal 32 acts as an additional layer of safety, ensuring that even if the cap 21 is not fitted correctly, the high-voltage system 11 is still in a fail-safe state.

In essence, this configuration prioritizes safety by using a lagged (staggered or sequential) contact mechanism that ensures that the capacitive voltage test system will always detect and warn about incomplete connections. This way, the risk of false readings or undetected errors is greatly reduced. It is a thoughtful configuration that puts the safety of operators and the reliability of the capacitive voltage test system at the forefront.

The proposed capacitive voltage test system ensures the integrity and reliability of voltage readings from the high-voltage system 11, and its importance cannot be overstated. The contact construction is such that the signal contact 23 never loses its electrical connection with the test point 2 before the ground contact 26 loses its conductive contact with the grounded surface 3 or 3.1 of the elbow connector 1. This intentional sequence provides a double-check mechanism to ensure correct cap mounting.

In conventional standard systems, an incorrectly mounted cap might provide an accurate ground connection, but an incomplete signal connection. This could give an inaccurate reading, suggesting no voltage presence, which can be dangerously misleading.

By configuring the ground contact 26 to lag behind, such a misleading scenario is avoided. If the signal contact 23 is made, but there is an interruption in the ground contact 26, the evaluation device 30 of the capacitive voltage test system will flag this as an error by emitting a corresponding warning signal 32 in the display of the evaluation device 30 (see FIG. 2). This proactive error detection means that operators will always be alerted to connection issues before they can make decisions based on potentially false readings.

By making the capacitive voltage test system foolproof, the chance of misinterpretation due to human error is significantly reduced. It minimizes the risks associated with high-voltage operations and instills greater confidence in operators about the accuracy of readings. Any discrepancies in connections are immediately flagged, ensuring quick remedial actions. In essence, the proposed configuration of the capacitive voltage system is all about 'safety first'. It combines smart engineering with built-in error detection to ensure that high-voltage operations are as safe as they can possibly be. It addresses a critical vulnerability in traditional voltage test systems and provides a robust solution.

The evaluation device 30 is essentially the 'brain' of this safety mechanism. Its primary task is to monitor and compare the signal levels of two distinct ground potentials. One ground potential 33 is inherently connected to the evaluation device 30 itself. This could be thought of as a reference or baseline potential. The other, the potential of system ground 9, originates from the elbow connector 1. This potential provides real-time data on the state and integrity of the connections in the high-voltage system 11, especially at the test point 2.

The potential of the system ground 9 is relayed to the evaluation device 30 through the shield 25 of the coaxial cable 24. This cable 24, known for its high fidelity in transmitting signals, ensures that the data reaching the evaluation device 30 is accurate and free from interference.

The evaluation device 30 constantly compares the two ground potentials. If they are the same, it confirms that the connections, in particular at the test point cap 21, have been made correctly and that the voltage shown on the voltage display 31 of the evaluation device 30 is therefore correct.

Any discrepancy between the two ground potentials signals a fault. This could be due to reasons like the test point cap 21 not making proper contact due to incorrect mounting or some other disruptions in the signal transmission pathway, in particular the signal line, typically resulting in a broken coaxial shield 25 covering the coaxial cable 24.

In the event of a detected discrepancy, the evaluation device 30 triggers a warning signal 32, immediately alerting the operator to the problem. This instantaneous feedback is crucial for ensuring the safety of both the operator and the equipment.

The warning signal 32 can be powered by a piezoelectric generator, eliminating the need for a continuous external power source. This ensures that the warning signal 32 is always ready to be activated when needed, without worrying about battery depletion or failure of the external power source. Piezoelectric systems are generally robust and have a long service life. Their simplicity means there are fewer parts to fail. For example, requiring the operator to press a TEST button ensures that he or she is actively involved in the process and is immediately alerted to any potential discrepancies or problems. The requirement to press a button can prevent false alarms or accidental activations. In addition, the power source (piezoelectric generator) for the warning signal 32 is isolated from the main system, ensuring that any faults in the main system will not affect the warning mechanism.

In the ideal scenario, both ground potentials should exhibit the same signal levels, implying that all connections, especially those of the cap 21, are properly established. However, if there is any discrepancy between the two ground potential levels, it indicates a fault (as in FIG. 2), likely due to the test point cap 21 not making correct contact. The evaluation device 30 then triggers a warning signal 32. This immediate feedback ensures that any misconnections or disconnections are instantly recognizable.

Immediate feedback is invaluable in high-voltage applications. A delayed response can lead to catastrophic results, potentially causing harm to equipment, the infrastructure, or the technicians themselves. The feedback mechanism is straightforward. There is no ambiguity in the indications given by the evaluation device 30. If the test point cap 21 is in proper contact and everything is functioning as it should, the evaluation device 30 remains clear of any warning signal 32.1 and thereby assures technicians that the voltage display 31 on the evaluation device 30 indicates the correct voltage. This is visually demonstrated in FIGS. 4 and 5.

On the other hand, the presence of the warning signal 32 (as in FIG. 2) is a definitive indicator of an issue. Such a binary (on/off) feedback system reduces the chances of misinterpretation. The feedback mechanism is proactive rather than reactive. The moment the cap 21 is not making the correct contact or any other issue arises, the warning signal 32 activates, potentially preventing bigger issues down the line. For example, in FIG. 2, the warning signal 32 alerts the technician before any larger malfunction or hazard develops. In high-voltage scenarios, safety cannot be emphasized enough. With this system, technicians are not left guessing. They know immediately when there is an issue, ensuring that any necessary corrective actions can be taken promptly.

In summary, the described capacitive voltage test system enhances safety and reliability for medium to high voltage operations. By continuously comparing ground potentials and providing immediate feedback to the user, the system ensures that voltage tests and related operations are carried out with a minimized risk of errors or oversights. It is a design that prioritizes user safety and system reliability, making sure that any potential connection issues are instantly flagged for corrective action.

The evaluation device 30 constantly juxtaposes two ground potentials. The first is its inherent ground potential 33 that is directly associated with the device 30. The second is relayed from the system ground 9 of the elbow plug 1, typically facilitated via the shield 25 of the coaxial cable 24. If these two potentials differ, it suggests there might be an inconsistency or flaw in the ground contact 26. Recognizing this discrepancy, the evaluation device 30 instantaneously triggers a warning signal 32. This immediate feedback mechanism is crucial, alerting the operator about a potential issue. In contrast, when the cap 21 is properly seated (correctly mounted) and there is no variance between the two ground potentials, the evaluation device 30 refrains from activating the warning signal 32.1 (see FIGS. 4 and 5). The lack of a warning signal 32.1 serves as an affirmation for the operator, indicating that the system is functioning as expected.

This configuration is a testimony to the importance of real-time monitoring and feedback in high-voltage operations. By continuously comparing the two ground potentials, the capacitive voltage test system can instantly detect and flag anomalies, bolstering safety and operational efficiency. For the operator, this means enhanced confidence in the system and the ability to make informed, timely decisions based on the feedback from the evaluation device 30.

The capacitive voltage test system according to FIGS. 4 and 5 also offers an advanced approach for partial discharge detection in medium to high voltage systems. In the medium or high voltage cable 6 of the termination (elbow connector 1 in this case), there is often a mix of signals ranging from the operating frequencies to higher frequency transients. These higher-frequency signals are typically associated with events like partial discharges (PD). The teaching of the present invention enables the extraction of these higher-frequency signals from the cable shield 5 without them getting mixed with the dominant operating frequency.

Once decoupled, the higher-frequency signals are then routed through a sequence of components: The contact point 7 is the starting point for the routed signal. Subsequently, after passing the grounded surface 3 (according to FIG. 4) or after passing an additional DC blocking capacitor 40 (according to FIG. 5) integrated into the ground connection line 4.1 that prevents any direct current (DC) from passing through but allows alternating current (AC), especially the higher-frequency signals, to pass, the higher-frequency signals reach the ground contact 26 in the test point cap 21, which is a key junction that ensures the signal remains grounded and does not induce unwanted interference in other parts. The signal line (coaxial cable 24 with shield 25) then carries the higher-frequency signals to the evaluation device 30. Once received by the evaluation device 30, these higher-frequency signals are processed through a separate signal path 35 configured specifically for partial discharge (PD) detection. This allows for precise and accurate PD detection without interference from the main operating frequencies.

In both FIG. 4 and FIG. 5, a low-pass filter 8 is positioned on the ground side of the contact point 7. This component has a dual function: It allows low-frequency or operating-frequency signals to be compared against the potential of the system ground 9. More importantly, it blocks higher-frequency signals from getting grounded, ensuring they are not lost or attenuated, making them available for PD analysis.

The alternative embodiment of the capacitive voltage test system, as illustrated in FIG. 5, offers a modified mechanism for decoupling higher-frequency signals, particularly associated with phenomena such as partial discharges. Unlike the previous embodiment of FIGS. 2 and 4 which necessitated a dedicated contact surface (grounded surface 3) on the elbow connector 1, this alternative embodiment simplifies the contact process. The ground contact 26 directly engages with the semiconducting housing 3.1 of the elbow plug 1. By doing so, it establishes an immediate signal path that enables a comparison between the potential of the ground 33 of the evaluation device and the potential of the system ground 9, which is crucial for verifying contact integrity.

Moreover, central to the alternative embodiment of FIG. 5 is the DC blocking capacitor 40. Its primary function is to prevent the potential of the system ground 9 from inadvertently short-circuiting with the coaxial cable shield 25 when it comes to low-frequency signals. By performing this action, the DC blocking capacitor 40 ensures that there is a clear demarcation between the low-frequency and high-frequency signal paths, facilitating accurate signal analysis.

The alternative configuration described above also protects against false positive contact verification. For example, if the test point cap 21 is not correctly mounted on the test point 2, the DC blocking capacitor 40 prevents the potential of the system ground 9 from being shorted to the coaxial cable shield 25 for low frequency signals and thus prevents the incorrectly mounted test point cap 21 from being overlooked due to the lack of a potential difference between the shield contact point 43 and the evaluation device ground 33.

Essentially, by ensuring that low-frequency signals do not create a potential difference inappropriately, the voltage test system verifies that any lack of detected ground potential difference is due to the proper functioning of the cap's connection.

In summation, the alternative decoupling method, as presented in FIG. 5, emphasizes streamlined contact verification while ensuring accurate separation of high-frequency and low-frequency signals. Such thoughtful engineering not only bolsters the reliability of the voltage test system but also enhances the safety standards by preventing false positives during operational checks.

The semiconducting housing 3.1 of the elbow plug 1, as disclosed in connection with FIG. 5, serves multiple important roles when it comes to signal transmission and grounding. The material and design of the semiconducting housing 3.1 of FIG. 5 are such that it offers excellent conductive properties for operational and low-frequency signals. This ensures efficient transmission and grounding for these signals. As the name suggests, a semiconducting material falls between a conductor (like metals) and an insulator (like rubber) in terms of its ability to conduct electricity. In the case of the elbow plug housing 3.1, the semiconducting material is tailored to be a good conductor for specific frequency ranges, particularly low frequencies. However, the semiconducting housing 3.1 of the elbow plug 1 of FIG. 5 inherently attenuates or weakens the high-frequency signals, so that the housing 3.1 acts somewhat like a low-pass filter, allowing low-frequency signals to pass through efficiently while reducing the amplitude of high-frequency signals.

Also in the alternative embodiment of FIG. 5, higher-frequency signals are decoupled from the primary flow of electrical current by leveraging the shield 5 of the medium-voltage or high-voltage cable 6. This is crucial, as partial discharges (PD) manifest as transient high-frequency bursts. The contact point 7 serves as a critical junction where the higher-frequency signals, including those from PD, are transitioned and forwarded for processing. The low-pass filter 8 blocks these higher-frequency signals from flowing down and being absorbed or neutralized by the potential of the system ground 9. This ensures that the PD signals remain intact and can be analyzed without being masked by other operational signals.

The DC blocking capacitor 40 ensures that only higher-frequency signals, like those from PD, continue along the intended path 4.1 and 42. Direct current (DC) and lower-frequency operational signals are blocked, ensuring that the PD signals remain distinct and unobscured. Once filtered and isolated, the higher-frequency PD signals are coupled at the shield contact point 43 into the shield 25 of the coaxial cable 6, which acts as the signal line for the evaluation device 30. At the evaluation device 30, the high-frequency signals from the coaxial cable shield 25 are directed towards the partial discharge detection system 34 via a separate signal path 35. Here, they are analyzed for characteristics that indicate the presence, magnitude, and type of PD activity.

The semiconducting housing 3.1 of the elbow plug 1 plays a pivotal role in ensuring that these high-frequency signals, including those from PD, are not inadvertently neutralized or diminished. Because of its poor high-frequency conductivity, the housing 3.1 acts as a barrier to short-circuiting these signals (along a short circuit from the shield contact point 43 to the ground contact 26 to the housing 3.1 to the housing ground line 10 and finally to the system ground 9), ensuring that they remain intact for evaluation in the evaluation device 30.

The low-pass filter 8, the ground connection line 4.1, the DC blocking capacitor 40, and the path 42 to the shield contact point 43, which are specifically tailored for the purpose of detecting partial discharges (PD) in the electrical system of Fig. 5, are of course dispensable if the additional PD detection function is not required.

In essence, the capacitive voltage test system according to the present invention is a blend of safety, accuracy, and adaptability. It is configured to minimize human error, ensure precise readings, and work efficiently with specific high-voltage terminations like elbow connectors 1. The system's capacitive nature means it reduces direct contact risks, while the built-in verification mechanism ensures detections and/or measurements are only made when contacts 23, 26 are correctly placed. This makes it a valuable tool for professionals working in medium to high voltage environments.

## Claims

1. A capacitive voltage test system configured to perform a voltage test on a medium to high voltage termination, in particular an elbow connector, comprising a capacitive test point which is capacitively coupled to a medium to high voltage cable of the termination for voltage detection and/or measurement, and a test point cap which is mounted on the capacitive test point, the test point cap having a signal contact configured to transmit a detection and/or measurement signal and a ground contact configured to derive a capacitive test signal, and the ground contact being configured to establish a conductive contact with a grounded surface of the termination only when the test point cap is correctly mounted on the capacitive test point and an electrical connection is established between the test point and the signal contact.

2. The capacitive voltage test system as in claim 1, further comprising an evaluation device connected to both the signal contact and the ground contact via a signal line, wherein the ground contact is configured to lag both mechanically and electrically behind the signal contact such that the evaluation device is configured to immediately detect an open ground contact and trigger a warning signal even if the signal contact remains connected to the test point.

3. The capacitive voltage test system as in claim 2, wherein the grounded surface is connected to system ground via a ground connection line passing through a low-pass filter integrated on the ground side of a contact point, where a shield of the cable is connected to the ground connection line, so that higher-frequency signals from the shield are routed away from the system ground through the contact point, the grounded surface, the ground contact and the signal line to the evaluation device for partial discharge detection.

4. The capacitive voltage test system as in claim 2, wherein the grounded surface is connected in a semiconducting manner to system ground and higher-frequency signals from a shield of the cable are routed through a contact point, a DC blocking capacitor, the ground contact and the signal line to the evaluation device for partial discharge detection, while a low-pass filter integrated on the ground side of the contact point blocks said higher-frequency signals from leaking from the shield into the system ground.

5. A medium to high voltage termination, in particular an elbow connector, equipped with a capacitive voltage system as in claim 1.
